# EUROPÄISCHE PATENTSCHRIFT

(11) **EP 1 642 331 B1**
(45) Veröffentlichungstag und Bekanntmachung des Hinweises auf die Patenterteilung: **03.04.2013**
(21) Anmeldenummer: 04741717.5
(22) Anmeldetag: 02.06.2004
(51) Int. Cl.: H01L 29/417, H01L 21/60

(54) **HERSTELLUNGSVERFAHREN EINER INTEGRIERTEN SCHALTUNGSANORDNUNG MIT NIEDEROHMIGEN KONTAKTEN**
METHOD FOR PRODUCTION OF AN INTEGRATED CIRCUIT ARRANGEMENT WITH LOW-RESISTANCE CONTACTS
PROCEDE DE FABRICATION D'UN ENSEMBLE CIRCUIT INTEGRE A CONTACTS DE BASSE IMPEDANCE

(30) Priorität: 08.07.2003 DE 10330730
(43) Veröffentlichungstag der Anmeldung: 05.04.2006
(60) Teilanmeldung: 10168883.6
(73) Patentinhaber: Infineon Technologies AG, 85579 Neubiberg (DE)
(72) Erfinder: HOFMANN, Franz, 80995 München (DE); LUYKEN, Richard Johannes, 81825 München (DE); RÖSNER, Wolfgang, 85521 Ottobrunn (DE); SPECHT, Michael, 80799 München (DE)
(74) Vertreter: Kindermann, Peter
(86) Internationale Anmeldenummer: PCT/EP2004/051004
(87) Internationale Veröffentlichungsnummer: WO 2005/006429

(56) Entgegenhaltungen:
- DE-A- 2 929 939
- US-A- 5 394 012
- US-A- 5 409 861

## Beschreibung

Die Erfindung betrifft ein Herstellungsverfahren einer integrierten Schaltungsanordnung, die ein Substrat aus Halbleitermaterial enthält. Direkt auf dem Substrat oder auf einer vom Substrat getragenen Zwischenschicht befindet sich eine elektrisch isolierende Isolierschicht, in der eine Aussparung angeordnet ist. Die Aussparung führt zum Substrat. In der Aussparung ist ein Anschlussbereich aus einem metallischen Material angeordnet, das aus einem Metall besteht oder ein Metall enthält. Zwischen dem Substrat und dem metallischen Anschlussbereich ist in der Aussparung eine Materiallage aus Halbleitermaterial angeordnet.

Das Halbleitermaterial des Substrats ist beispielsweise monokristallines Silizium oder ein anderes Halbleitermaterial, beispielsweise auch ein Verbindungshalbleitermaterial. Das elektrisch isolierende Material ist beispielsweise Siliziumdioxid oder ein anderes isolierendes Material bzw. Oxid. Als Material für den Anschlussbereich sind insbesondere Silizide geeignet, die einerseits im Vergleich zu dem Halbleitermaterial der Materiallage eine höhere Leitfähigkeit haben und die aber auch gut auf der Materiallage aus Halbleitermaterial anhaften.

Aus der DE 29 29 939 A1 ist ein Verfahren bekannt, bei dem eine Kontaktfläche im Querschnitt wellen-, sägezahn- oder mäanderförmig strukturiert wird, um den Übergangswiderstand zwischen Halbleiter und Metall zu verringern. Aus der US 5,394,012 sind sublithografische Verfahren zur Verringerung des Kontaktwiderstands bzw. zur Vergrößerung der Oberfläche eines Kondensators bekannt. Dabei wird eine polykristalline HSG (HemiSpherical Grain) Schicht erzeugt, die anschließend mit einem anisotropen oder isotropen Ätzverfahren vollständig entfernt wird, wodurch die HSG Oberflächenstruktur auf die Kontaktoberfläche übertragen wird.

Es ist Aufgabe der Erfindung, ein Herstellungsverfahren für eine einfach aufgebaute integrierte Schaltungsanordnung mit geringem Kontaktwiderstand anzugeben.

Die auf das Herstellungsverfahren der Schaltungsanordnung bezogene Aufgabe wird durch ein Herstellungsverfahren mit den im Patentanspruch 1 angegebenen Merkmalen gelöst. Eine Weiterbildung ist in dem Unteransprüch angegeben.

Die Erfindung geht von der Überlegung aus, dass bei einer fortschreitenden Verkleinerung der Bauelemente in der Mikroelektronik der Widerstand, der mit dem Übertritt des Stroms von einem metallisch leitfähigen Gebiet in hochdotiertes Halbleitermaterial verbunden ist, d.h. der sogenannte Ohmsche Kontaktwiderstand, einen immer größeren Anteil am Gesamtwiderstand einer elektrisch leitfähigen Verbindung bekommt. Geht man davon aus, dass sich alle Abmessungen in der integrierten Schaltungsanordnung linear verkleinern, wobei natürlich die Dotierstoffkonzentrationen in geeigneter Weise angepasst werden müssen, dann bleibt das Verhältnis von Weite eines Transistors zur Länge eines Transistors gleich. Durch die ebenfalls verkleinerte Gateoxid-Dicke nimmt der sogenannte Einschaltwiderstand des Transistors insgesamt ab. Der Ohmsche Kontakt andererseits ist charakterisiert durch einen spezifischen Flächenwiderstand, der vom Leitermaterial und der Dotierstoffkonzentration im Halbleiter abhängt. Gute Werte liegen beispielsweise im Bereich von 10⁻⁷ bis 10⁻⁶ Ω cm² (Ohm mal Quadratzentimeter) bzw. 10 bis 100 Ω µm². Damit würde ein Kontaktwiderstand von 10 bis 100 Ω eine Fläche von 1 µm² erfordern. Wenn aber die Abmessungen verkleinert werden, dann nimmt der Kontaktwiderstand quadratisch mit dem linearen Skalierungsfaktor zu.

Zur Verringerung des Kontaktwiderstandes, siehe DE 29 29 939, bei einer Verringerung der für den Kontakt lateral benötigten Kontaktfläche kann deshalb bei einer integrierten Schaltungsanordnung eine parallel zur Oberfläche des Substrats liegende Übergangsschicht verwendet werden, die von mehreren Teilbereichen der Materiallage und/oder von mehreren Teilbereichen des Anschlussbereiches durchdrungen wird, die im Fall der Teilbereiche der Materiallage in der Übergangs schicht vollständig von metallischem Material des Anschlussbereiches oder die im Fall der Teilbereiche des Anschlussbereiches in der Übergangsschicht vollständig von Halbleitermaterial umgeben sind. Es reicht also aus, wenn in der Übergangsschicht nur mehrere separate Teilbereiche der Materiallage vorhanden sind, die bspw. von einem zusammenhängenden Teilbereich des Anschlussbereiches umgeben sind. Ebenso reicht es aus, wenn in der Übergangsschicht nur mehrere separate Teilbereiche des Anschlussbereiches vorhanden sind, die bspw. von einem zusammenhängenden Teilbereich der Materiallage umgeben sind.

Die Übergangsschicht hat eine Schichtdicke größer als 10 nm und hat vorzugsweise eine gleichmäßige Schichtdicke mit Dickeschwankungen unter 10 Prozent der mittleren Schichtdicke. Durch diese Art von Verzahnung des metallischen Anschlussbereiches und der halbleitenden Materiallage wird die Kontaktfläche bei gleichen lateralen Abmessungen erheblich vergrö-βert, insbesondere um mehr als 50 % oder sogar um mehr als 100 % verglichen mit einer Übergangsschicht, die nur eine Schichtdicke kleiner als 1 nm hat, wie sie im atomaren Bereich oder auf der Gitterebene vorhanden ist.

Bei so einer integrierten Schaltungsanordnung wird die Grenzfläche zwischen dem metallischen Anschlussbereich und der halbleitenden Materiallage durch Methoden der Oberflächenvergrößerung gezielt erhöht. Geeignet hierfür sind nicht erfindungsgemäß einerseits Abscheidemethoden, die Halbleitermaterial mit nicht-planarer Oberfläche erzeugen, wie z.B. hemispherical grain (HSG) polykristallines Silizium. Weiterhin kommen Verfahren in Frage, die aus bereits existierendem Halbleitermaterial Teilbereiche entfernen, so dass eine nicht-planare Oberfläche entsteht, wie z.B. das Ätzen von Poren oder Gräben mit einer selbstorganisiert erzeugten Maske.

Durch das mehrfache Durchdringen der Übergangsschicht und durch die Ausbildung der verzahnten Bereiche mit spitzen Ecken oder spitzen Kanten entstehen außerdem Spannungsspitzen, die den Kontaktwiderstand weiterhin verringern, beispielsweise dadurch, dass sie Tunnelströme ermöglichen.

Beispielsweise wird die Übergangsschicht von mindestens zehn oder von mindestens hundert Teilbereichen der Materiallage durchdrungen, die alle in der Übergangsschicht vollständig von metallischem Material umgeben sind. Alternativ oder zusätzlich durchdringen mindestens zehn oder mindestens hundert Teilbereiche des Anschlussbereiches die Übergangsschicht. Beispielsweise hat die Aussparung eine Fläche kleiner als 1 µm² oder kleiner als 0,25 µm², so dass beispielsweise bei hundert Durchdringungen auf einem so kleinen Flächenbereich die Grenzfläche zwischen der halbleitenden Materiallage und dem metallischen Anschlussbereich erheblich vergrößert und damit der ohmsche Widerstand des Übergangs verkleinert wird. Beispielsweise enthält die Übergangsschicht mehr Material der Materiallage als Material des Anschlussbereiches. Ist das Volumenverhältnis zwischen dem Material der Materiallage und dem Material des Anschlussbereiches insbesondere größer als 60:40 oder größer als 70:30, wird erreicht, dass von dem elektrisch schlechter leitenden Halbleitermaterial ein größerer Materialanteil in der Übergangsschicht enthalten ist als von dem im Vergleich dazu elektrisch besser leitendem metallischen Material. Auch durch diese Maßnahme verringert sich der Kontaktwiderstand erheblich.

Beispielsweise reichen die die Übergangsschicht durchdringenden Teilbereiche des Anschlussbereiches an das Substrat heran. Mit anderen Worten liegt die untere Grenze der Übergangsschicht beispielsweise nur weniger als 5 nm oder nur weniger als 3 nm über dem Substrat. Damit wird die halbleitende Materiallage von den Anschlussbereichen vollständig oder fast vollständig durchdrungen. Auch diese Maßnahme führt zu einer sehr großen Oberflächenvergrößerung der Grenzfläche zwischen metallischem Anschlussbereich und vorzugsweise hochdotiertem Halbleitermaterial der Materiallage.

Es enthält die Materiallage monokristallines Halbleitermaterial bzw. besteht die Materiallage aus monokristallinem Halbleitermaterial, beispielsweise aus epitaktisch aufgewachsenem Halbleitermaterial. Das monokristalline Halbleitermaterial hat im Vergleich zu polykristallinem Halbleitermaterial eine höhere elektrische Leitfähigkeit. Es sind in der Materiallage Löcher oder Gräben, die Material des Anschlussbereiches enthalten. Herstellungsmöglichkeiten für solche Löcher oder Gräben werden unten angegeben. Die Löcher haben vorzugsweise parallel zur Substratoberfläche liegende Querschnitte mit spitzwinkligen Ecken zum Erzeugen von Feldspitzen. Die Gräben bilden vorzugsweise Ringstrukturen, d.h. sie haben keinen Anfang und kein Ende. Beispielsweise haben die Löcher bzw. die Gräben eine Tiefe, die erheblich größer als die kleinste laterale Breite eines Lochs bzw. Grabens ist. Beispielsweise sind die Gräben mindestens doppelt so tief wie breit oder mindestens drei mal so tief wie breit; z.B. beträgt die Tiefe mehr als 10 nm, mehr als 20 nm oder mehr als 30 nm.

Alternativ enthält die Materiallage polykristallines Halbleitermaterial oder besteht aus polykristallinem Halbleitermaterial, insbesondere aus polykristallinem Silizium. In der Materiallage sind wiederum Löcher oder Gräben, die Material des Anschlussbereiches enthalten, vorzugsweise Löcher mit eckigen Querschnitten oder Ringstrukturen bildende Gräben. Die Löcher bzw. Gräben sind vorzugsweise so, dass Körner des polykristallinen Materials durchdrungen werden. Mit anderen Worten besteht zwischen der Lage der Löcher oder Gräben und der Lage von Korngrenzen der Körner des polykristallinen Halbleitermaterials kein Zusammenhang. Dies ist der Fall, wenn zum Erzeugen der Gräben Korngrenzen einer Hilfsschicht verwendet werden, die nach dem Erzeugen einer Maske entfernt wird. Dieses Verfahren wird weiter unten näher erläutert. Innerhalb eines Korns liegt abgesehen von lokalen Gitterstörungen einkristallines Material vor, d.h. ein regelmäßig aufgebautes Gitter.

Bei einer anderen alternativen nicht erfindungsgemäßen Weiterbildung besteht die Materiallage ebenfalls aus polykristallinem Halbleitermaterial bzw. enthält die Materiallage polykristallines Halbleitermaterial. Die Lage der die Übergangsschicht durchdringenden Teile des Anschlussbereiches ist bei dieser Weiterbildung jedoch durch die Lage von Korngrenzen der Körner des polykristallinen Halbleitermaterials vorgegeben. Beispielsweise wird die Lage der die Übergangsschicht durchdringenden Teile des Anschlussbereiches bei hemisphärisch abgeschiedenen polykristallinen Schichten durch die Lage von Korngrenzen vorgegeben.

Bei einer anderen nicht erfindungsgemäßen Weiterbildung mit beispielsweise hemisphärisch abgeschiedenen Körnern enthält die Materiallage nur eine Lage von Körnern. Mindestens 80 % der Körner sind durch Abstände von anderen Körnern getrennt, so dass keine durchgehende Schicht erzeugt wird. Durch diese Maßnahme ist nur wenig polykristallines Material in der Aussparung enthalten, das im Vergleich zu dem Substrat bzw. dem Anschlussbereich eine geringere elektrische Leitfähigkeit hat. Andererseits sind die Körner jedoch bei einer Ausgestaltung nicht so weit voneinander entfernt, dass der Abstand zwischen Körnern größer als der mittlere Korndurchmesser ist. Auch durch diese Maßnahme wird gewährleistet, dass die Grenzfläche zwischen Anschlussbereich und Halbleitermaterial groß ist.

Beispielsweise enthält der Anschlussbereich Silizid oder er besteht aus einem Silizid, insbesondere aus Titansilizid, Kobaltsilizid oder Nickelsilizid. Das Silizid wird vorzugsweise mit einem Abscheideverfahren direkt aus der Gasphase abgeschieden, so dass das Material der Materiallage beim Aufbringen des Silizides nicht abgebaut wird, wie es bei einer Umwandlung eines aufgesputterten Metalls in Silizid der Fall wäre. Durch diese Maßnahme lässt sich ein großer Anteil von Material der Materiallage in der Übergangsschicht gewährleisten, so dass insgesamt ein kleiner Kontaktwiderstand erreicht wird.

Beispielsweise ist der Anschlussbereich mit einem Anschluss aus Metall elektrisch leitend verbunden. Die Aussparung verjüngt sich zum Anschluss hin mit zunehmendem Abstand vom Substrat. Insbesondere hat die Aussparung parallel zur Substratoberfläche eine größere Querschnittsfläche als eine parallel zur Substratoberfläche liegende Querschnittsfläche durch den Anschluss. So ist die Querschnittsfläche der Aussparung bei einer Ausgestaltung mehr als 50 % oder mehr als 100 % größer als die Querschnittsfläche des Anschlusses. Durch diese Maßnahme befindet sich der Metall-Halbleiter-Kontakt nicht nur am Boden des Kontaktloches für den Anschluss, sondern in einem Bereich, der sich auch seitlich des Kontaktlochbodens erstreckt. Durch diese Maßnahme lässt sich der Kontaktwiderstand weiter verringern. Während das Kontaktloch mit einem fotolithografischen Verfahren erzeugt wird, lässt sich der Anschlussbereich selbstjustierend durch eine selektive Abscheidung oder auf andere Art erzeugen.

Beispielsweise ist am Boden der Aussparung im Substrat ein dotiertes Anschlussgebiet eines Transistors angeordnet, insbesondere ein Drain-/Source-Gebiet eines MOS-Transistors (Metall Oxide Semiconductor) bzw. eines Transistors mit isoliertem Gate. Alternativ ist am Boden der Aussparung im Substrat eine dotierte Isolierwanne angeordnet, die zur Isolation von Bereichen mit aktiven Bauelementen vom Substrat dient.

Beispielsweise ist die Materiallage dotiert, insbesondere mit einer Dotierstoffkonzentration größer als 10¹⁸ Dotieratome pro cm³.oder größer als 10²⁰ Dotieratome pro cm³, z.B. 10²¹ Dotieratome pro cm³. Je höher die Dotierstoffkonzentration ist, um so geringer ist der elektrische Widerstand des Materials der Kontaktlage. Insbesondere wird so hoch dotiert, dass ein sogenannter "entarteter" Halbleiter entsteht, der Eigenschaften einer metallischen Leitung hat.

Beispielsweise enthält das Substrat anorganisches Halbleitermaterial oder besteht vollständig aus anorganischem Halbleitermaterial, insbesondere aus Silizium.

Beispielsweise ist die Dicke der Übergangsschicht größer als 20 nm oder größer als 30 nm. Mit größer werdender Schichtdicke der Übergangsschicht vergrößert sich die erreichbare Oberflächenvergrößerung der Grenzschicht zwischen Anschlussbereich und halbleitender Materiallage. Die obere Grenze wird jedoch bspw. durch die Schichtdicke der Schicht mit der Aussparung bestimmt.

Die Erfindung betrifft ein Verfahren zum Herstellen einer integrierten Schaltungsanordnung mit den ohne Beschränkung durch die angegebene Reihenfolge ausgeführten Verfahrensschritten:
Bereitstellen eines Substrats,
Herstellen mindestens eines elektronischen Bauelementes in oder auf dem Substrat,
Aufbringen einer elektrisch isolierenden Isolierschicht nach der Herstellung des Bauelementes,
Erzeugen mindestens einer in der Isolierschicht angeordneten Aussparung,
Einbringen eine halbleitenden Materiallage aus monokristallinem oder polykristallinem Material in die Aussparung,
Aufbringen einer Maskenschicht nach dem Einbringen der Materiallage,
Aufbringen einer polykristallinen Schicht nach dem Aufbringen der Maskenschicht,
Ätzen der polykristallinen Schicht an Korngrenzen, wobei Kornmittenbereiche und vorzugsweise Korngrenzenbereiche zwischen nur zwei benachbarten Körnern nicht weggeätzt werden, Nutzen der Kornmittenbereiche zum Strukturieren der Maskenschicht in einem Ätzprozess,
Strukturieren der Materiallage unter Nutzung der Maskenschicht,
Aufbringen einer metallischen Schicht nach dem Strukturieren der Materiallage, wobei sich Teile der metallischen Schicht in die strukturierte Materiallage hinein erstrecken.

Im Zusammenhang mit einer solchen Folge von Verfahrensschritten wird in Hinblick auf die Nutzung der sich selbständig ausbildenden Korngrenzen auch vom Erzeugen einer selbstorganisierten Maske gesprochen. Insbesondere ist das Verfahren nicht von einer bestimmten Belichtungswellenlänge abhängig wie es bei fotolithografischen Verfahren der Fall ist. Alternative nicht erfindungsgemäße Verfahren zum Strukturieren der Materiallage unterhalb der mit einem fotolithografischen Verfahren minimal zu ätzenden Strukturbreite sind beispielsweise die Bestrahlung einer strahlungsempfindlichen Schicht mit einer Teilchenstrahlung, z.B. mit einem Elektronenstrahl.

Bei einer alternativen nicht erfindungsgemäßen Verfahrensführung wird die Materiallage mit einem sogenannten HSG-Verfahren hergestellt (Hemispherical Growth). Diese Verfahren wurden zur Vergrößerung der Oberfläche von Kondensatorplatten entwickelt und optimiert. Beispielsweise werden drei Verfahrensschritte durchgeführt:
Erzeugen einer polykristallinen Grundschicht,
Erzeugen von Keimen in der polykristallinen Grundschicht, und
Erzeugen des Kornwachstums in der polykristallinen Grundschicht. Jedoch lassen sich die Körner auch direkt aus der Gasphase erzeugen, d.h. ohne das vorherige Aufbringen einer Grundschicht.

In einer Weiterbildung des erfindungsgemäßen Verfahrens wird die metallische Schicht direkt aus der Gasphase mit einem Abscheideverfahren auf die strukturierte Materiallage aufgebracht, insbesondere durch ein CVD-Verfahren (Chemical Vapor Deposition). Eine nachträgliche Materialumwandlung wie beim Aufsputtern eines Metalls auf Silizium und anschließender Temperung zur Bildung von Silizid ist dadurch nicht erforderlich.

Im Folgenden wird ein Ausführungsbeispiel der Erfindung an Hand der beiliegenden Zeichnungen erläutert. Darin zeigen:
Figur 1 geometrische Entwürfe bzw. Layouts für Masken zur Erzeugung eines MOS-Transistors,
Figuren 2A und 2B Herstellungsstufen eines Transistors gemäß einem Verfahren mit selbstorganisierter Strukturierung, und
Figuren 3A und 3B Herstellungsstufen eines Transistors gemäß einem nicht erfindungsgemäßen HSG-Verfahren (Hemispherical Grain Growth).

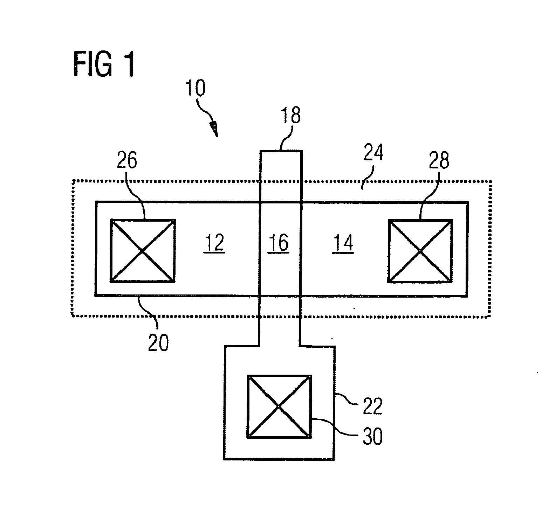

Figur 1 zeigt die Zuordnung zwischen geometrischen Entwürfen für einen Transistor 10 und Bereichen in einem Substrat. Das Substrat enthält ein beispielsweise n-dotiertes Source-Gebiet 12 und ein n-dotiertes Drain-Gebiet 14. Zwischen dem Source-Gebiet 12 und dem Drain-Gebiet 14 liegt im Substrat ein p-dotierter Kanalausbildungsbereich 16, der von einem Gate-Bereich 18 überdeckt wird. Zum Erzeugen des Source-Bereiches 12 und des Drain-Bereiches 14 wird eine Isolationsmaske 20 verwendet, mit deren Hilfe Grenzen von Isoliergebieten um den Transistor 10 herum festgelegt werden, d.h. im Ausführungsbeispiel durch ein langgestrecktes rechteckförmiges Gebiet.

Die Lage des Gate-Bereiches 18 und des Kanalausbildungsbereiches 16 wird durch eine Gatemaske 22 festgelegt, die ein im Vergleich zu dem Rechteck der Isolationsmaske 20 schmales Rechteck enthält, das quer zu dem Rechteck der Isolationsmaske 20 angeordnet ist. An dem einen Ende des schmalen Rechtecks schließt sich ein im Vergleich zur kurzen Seite des schmalen Rechtecks breiteres Quadrat an, um einen Kontaktbereich für einen Gatekontakt festzulegen.

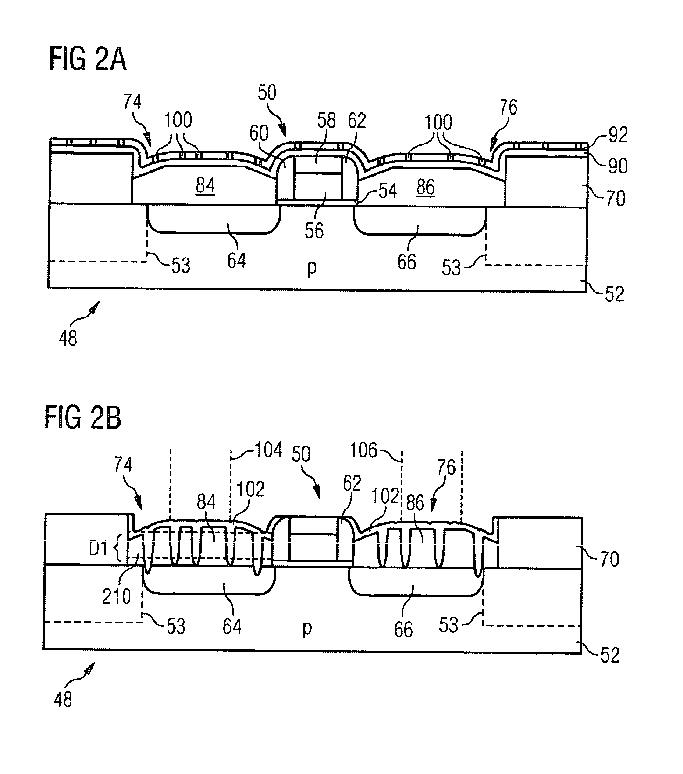

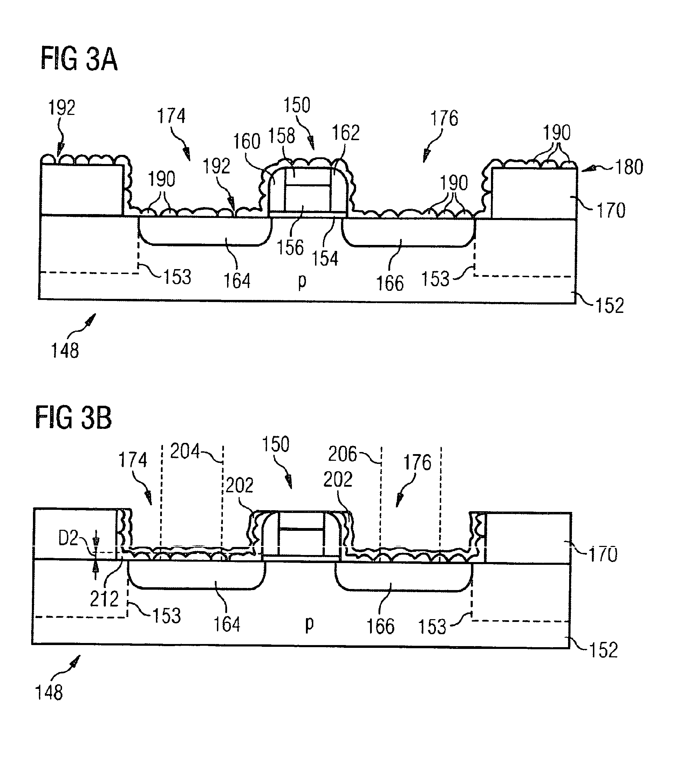

Die Funktion einer Hilfsmaske 24 zum Festlegen der Lage von Aussparungen für Anschlussbereiche wird unten an Hand der Figuren 2A und 2B bzw. der Figuren 3A und 3B erläutert. Die Hilfsmaske 24 legt um den Source-Bereich 12 und den Drain-Bereich 14 herum ein rechteckförmiges Gebiet fest. Das rechteckförmige Gebiet der Hilfsmaske 24 ist etwas größer als das rechteckförmige Gebiet der Isolationsmaske 20. Das rechteckförmige Gebiet der Hilfsmaske 24 und das rechteckförmige Gebiet der Isolationsmaske 20 sind zentriert zueinander angeordnet.

Eine Kontaktmaske legt die Lage eines Source-Kontaktes 26 am linken Ende des Source-Bereiches 12, die Lage eines Drain-Kontaktes 28 am rechten Rand des Drain-Bereiches 14 und die Lage eines Gate-Kontaktes 30 am Ende des Gate-Bereiches 18 fest.

Die Figuren 2A und 2B zeigen für eine integrierte Schaltungsanordnung 48 Herstellungsstufen eines Transistors 50 unter Verwendung eines Verfahrens mit selbstorganisierter Strukturierung. Ausgehend von einem p-dotierten Siliziumsubstrat 52 werden nacheinander, Isolierbereiche 53 mit der Isolationsmaske 20, eine Gateoxidschicht zur Erzeugung eines Gateoxidbereiches 54, eine hochdotierte polykristalline Schicht zur Erzeugung eines Gate-Bereiches 56 und eine Schutzschicht, z.B. eine Siliziumnitridschicht, zum Erzeugen eines Schutzbereiches 58 oberhalb des Gate-Bereiches 56 abgeschieden. Anschließend werden in einem fotolithografischen Verfahren mit Hilfe der Gatemaske 22 der Gate-Bereich 56 und der Schutzbereich 58 strukturiert. Danach werden elektrisch isolierende Abstandselemente bzw. Spacer 60, 62, bspw. aus Siliziumnitrid oder Siliziumdioxid, an den Seiten des Gate-Bereiches 56 und des Schutzbereiches 58 erzeugt.

In einem nächsten Verfahrensschritt werden mit Hilfe der Isolationsmaske 20 selbstjustierend zu den Abstandselementen 60, 62 und zum Gate-Bereich 56 ein n-dotierter Source-Bereich 64 und ein n-dotierter Drain-Bereich 66 erzeugt.

Anschließend wird eine elektrisch isolierende Isolierschicht 70 beispielsweise in einer Schichtdicke von 200 nm abgeschieden. Die Isolierschicht 70 ist bspw. eine Oxidschicht, insb. eine Siliziumdioxidschicht, die beispielsweise mit einem TE-OS-Verfahren (Tetra Ethyl Ortho Silicate) abgeschieden wird. Anschließend wird die Isolierschicht 70 planarisiert, beispielsweise mit Hilfe eines CMP-Verfahrens (Chemical Mechanical Polishing).

In einem folgenden Verfahrensschritt werden oberhalb des Source-Bereiches 64 bzw. oberhalb des Drain-Bereiches 66 in einem fotolithografischen Verfahren unter Verwendung der Hilfsmaske 24 zwei Aussparungen 74 und 76 in der Isolierschicht 70 geöffnet. Dies erfolgt selbstjustierend zu dem von den Abstandselementen 60, 62 und von dem Schutzbereich 58 umgebenen Gate-Bereich 56.

In einem nachfolgenden Verfahrensschritt werden mit Hilfe einer selektiven Siliziumepitaxie auf dem Source-Bereich 64 ein Epitaxiebereich 84 und auf dem Drain-Bereich 66 ein Epitaxiebereich 86 erzeugt, beispielsweise in einer Dicke von 150 nm. Die Epitaxiebereiche 84, 86 werden möglichst hoch dotiert. Beispielsweise durch eine in-situ-Dotierung oder durch eine nachträgliche Implantation nach der Epitaxie. Auch wird bei einem anderen Ausführungsbeispiel trotz einer in-situ Dotierung eine Implantation durchgeführt, um die Dotierung der Epitaxiebereiche 84, 86 zu erhöhen.

Danach werden Poren in den Epitaxiebereichen 84 und 86 erzeugt, mit Hilfe einer sublithografischen selbstorganisierten Maske für die Poren. Bei der Herstellung der sublithografischen selbstorganisierten Maske für die Poren wird wie folgt vorgegangen:
- Abscheiden einer dünnen TEOS-Schicht 90, die z.B. eine Dicke von 20 nm hat,
- Abscheiden einer dünnen polykristallinen Siliziumschicht 92, die z.B. eine Dicke von 30 nm hat,
- nass-chemisches Ätzen der polykristallinen Schicht 92, so dass im Bereich der Korngrenzen, an denen drei oder mehr Körner aneinandergrenzen, Löcher 100 mit dreieckigen, rhombusartigem oder mehreckigen Querschnitten entstehen. Die Löcher haben demzufolge spitzwinklige Kanten mit Winkeln zwischen den Seitenflächen innerhalb eines Loches von kleiner 90°.
- Trockenätzen der TEOS-Schicht 90 unter Verwendung der Reste der polykristallinen Schicht 92 als Maske, wobei die Löcher 100 bis in die TEOS-Schicht 90 erstreckt werden,
- Erweitern der Löcher 100 bis in die Epitaxiebereiche 84, 86 mit Hilfe eines Trockenätzverfahrens und unter Verwendung der TEOS-Schicht 90 als Maske.

Wie in Figur 2B dargestellt, werden danach die Reste der polykristallinen Schicht 92 und der TEOS-Schicht 90 entfernt. Danach wird beispielsweise mit Hilfe eines CVD-Verfahrens (Chemical Vapor Deposition) eine Silizidschicht 102 direkt aus der Gasphase abgeschieden, die auch die in die Epitaxiebereiche 84, 86 erstreckten Löcher 100 füllt. Die Löcher 100 reichen bis an das Substrat 52 heran und dringen teilweise sogar in das Substrat 52 ein.

Anschließend wird die Silizidschicht 102 außerhalb der Aussparungen 74, 76 entfernt, beispielsweise mit Hilfe eines CMP-Verfahrens (Chemical Mechanical Polishing). Danach wird ein BEOL-Prozess (Back End Of Line) durchgeführt, bei dem Metallisierungen erzeugt werden, insbesondere ein Source-Kontakt 104 und ein Drain-Kontakt 106.

Bei anderen Ausführungsbeispielen werden an Stelle der TEOS-Schicht 90 andere Materialien eingesetzt, beispielsweise Siliziumnitrid. Bei einem anderen Ausführungsbeispiel wird die polykristalline Schicht 92 nass-chemisch so geätzt, dass im Bereich der Korngrenzen ringförmige und untereinander verbundene Löcher 100 entstehen. Danach werde die Gräben bis in die TEOS-Schicht 90 und bis in die Epitaxiebereiche 84, 86 erstreckt.

Bei einem weiteren Ausführungsbeispiel wird ein nicht selektiver Epitaxieprozess ausgeführt, bspw. mit Hilfe eines CVD-Verfahrens (Chemical Vapor Deposition). Dabei werden die Epitaxiebereiche 84, 86 monokristallin ausgebildet. Außerhalb der Aussparungen 74 und 76 entstehen dagegen polykristalline Bereiche, die anschließend bspw. mit einem CMP-Verfahren (Chemical Mechanical Polishing) wieder entfernt werden.

An Hand der Figuren 3A und 3B wird im Folgenden für eine integrierte Schaltungsanordnung 148 ein nicht erfindungsgemäßes Herstellungsverfahren eines Transistors 150 erläutert, der zunächst wie der Transistor 50 hergestellt wird, wobei in bzw. auf einem p-dotierten Siliziumsubstrat 152 Isolierbereiche 153, ein Gateoxidbereich 154, ein Gate-Bereich 156, ein Schutzbereich 158 und Abstandselemente 160 und 162 erzeugt werden.

Mit Hilfe der Isolationsmaske 20 werden außerdem ein Source-Bereich 164 und ein Drain-Bereich 166 erzeugt. Anschlie-βend wird eine TEOS-Schicht 170 abgeschieden und mit Hilfe eines CMP-Verfahrens planarisiert. Mit der Hilfsmaske 24 werden dann selbstjustierend zum Gatebereich 156 sowie zu den Abstandselementen 160 und 162 die örtlichen Lagen der Aussparungen 174 und 176 oberhalb des Source-Bereiches 164 bzw. des Drain-Bereiches 166 festgelegt. Die Aussparungen 174 und 176 werden dann in einem Ätzprozess erzeugt.

Anschließend wird mit Hilfe eines HSG-Verfahrens eine einlagige Schicht 180 aus Siliziumkörnern 190 erzeugt, von denen jeweils mindestens die Hälfte der Kornoberfläche freiliegt. Zwischen benachbarten Siliziumkörnern 190 gibt es auch Lücken 192, an denen das Substrat 152 frei liegt. Die Siliziumkörner werden vorzugsweise in-situ, d.h. beim Abscheideprozess, möglichst hoch dotiert.

Anschließend wird beispielsweise mit Hilfe eines CVD-Verfahrens (Chemical Vapor Deposition) eine Silizidschicht 202 direkt aus der Gasphase abgeschieden. Dabei wird ein Silizium enthaltendes Gas verwendet, z.B. Silan SiH₄ und/oder SiH₂Cl₂. Im Zusammenhang mit der CVD-Abscheidung von Silizidschichten wird bspw. auf den Fachartikel "Selective Deposition of TiSi₂ on ultra-thin silicon-on-insulator (SOI) Wafers" von Jer-Shen Maa et al., Thin Solid Films 332 (1998), pp. 412-417, verwiesen. Danach werden die Silizidschicht 202 und die Schicht 180 außerhalb der Aussparungen 174 und 176 beispielsweise mit Hilfe eines CMP-Verfahrens entfernt.

Weiterhin wird mit Hilfe eines BEOL-Verfahrens eine Metallisierung aufgebracht, wobei in der Aussparung 174 ein Source-Kontakt 204 und in der Aussparung 176 ein Drain-Kontakt 206 erzeugt werden. Der Source-Kontakt 204 bedeckt beispielsweise nur eine Grundfläche des Substrats 152, die kleiner als die halbe Fläche ist, die von der Aussparung 174 bedeckt wird. Bei dem erläuterten Ausführungsbeispiel gibt es eine stark nicht-planare Grenzfläche zwischen metallisch leitfähigem Gebiet und hochdotiertem Halbleiter der Epitaxiebereiche 84, 86 bzw. der Schicht 180. Das grundlegende Prinzip liegt in der Verwendung oberflächenvergrößernder Maßnahmen bei der Herstellung der Grenzfläche zwischen metallisch leitfähigem Gebiet 102, 202 und hochdotiertem Halbleiter 84, 86 bzw. 180. Die Oberflächenvergrößerung tritt insbesondere in einer parallel zum Substrat 52 bzw. zum Substrat 152 liegenden Übergangsschicht 210 bzw. 212 auf. Die Übergangsschicht 210 der Schaltungsanordnung 58 hat eine Dicke D1 größer als 15 nm, insbesondere eine Dicke D1 größer 100 nm. Die Übergangsschicht 212 der Schaltungsanordnung 148 hat eine geringere Dicke D2 als die Dicke D1 der Übergangsschicht 210. Im Ausführungsbeispiel beträgt die Dicke D2 der Übergangsschicht 212 beispielsweise 20 nm. Bei anderen Ausführungsbeispielen liegt die Dicke D2 der Übergangsschicht 212 zwischen 20 nm und 40 nm.

## Patentansprüche

1. Verfahren zum Herstellen einer integrierten Schaltungsanordnung (48), mit den ohne Beschränkung durch die angegebene Reihenfolge ausgeführten Verfahrensschritten:
Bereitstellen eines Substrats (52),
Herstellen mindestens eines elektronischen Bauelementes (50) in oder auf dem Substrat (52),
Aufbringen einer elektrisch isolierenden Isolierschicht (70) nach dem Herstellen des Bauelementes (50), Erzeugen mindestens einer in der Isolierschicht (70) angeordneten Aussparung (74, 76),
Einbringen einer halbleitenden Materiallage (84, 86), aus monokristallinem oder polykristallinem Material, in die Aussparung (74, 76),
Aufbringen einer Maskenschicht (90) nach dem Einbringen der Materiallage (84, 86),
Aufbringen einer polykristallinen Schicht (92) nach dem Aufbringen der Maskenschicht (90),
Ätzen der polykristallinen Schicht (92) an Korngrenzen, wobei Kornmittenbereiche und vorzugsweise Korngrenzenbereiche zwischen nur zwei benachbarten Körnern nicht weggeätzt werden,
Nutzen der Kornmittenbereiche und vorzugsweise der verbliebenen Korngrenzenbereiche zum Strukturieren der Maskenschicht (90) in einem Ätzprozess,
Strukturieren der Materiallage (84, 86) mit Hilfe der Maskenschicht (90),
Aufbringen einer metallischen Schicht (102) nach dem Strukturieren der Materiallage (84, 86),
wobei sich Teile der metallischen Schicht (102) in die strukturierte Materiallage (84, 86) hinein erstrecken.

2. Verfahren nach Anspruch 1, **dadurch gekennzeichnet, dass** die metallische Schicht (102) mit einem Abscheideverfahren auf die strukturierte Materiallage aufgebracht wird, insbesondere mit einem Verfahren bei dem ein Silizid aus der Gasphase abgeschieden wird.

## Claims

1. Method for producing an integrated circuit arrangement (48), comprising the following method steps that are performed without restriction by the order specified:
providing a substrate (52),
producing at least one electronic component (50) in or on the substrate (52),
applying an electrically insulating insulation layer (70) after producing the component (50),
producing at least one cutout (74, 76) arranged in the insulation layer (70),
introducing a semiconducting material layer (84, 86), composed of monocrystalline or polycrystalline material, into the cutout (74, 76),
applying a mask layer (90) after introducing the material layer (84, 86),
applying a polycrystalline layer (92) after applying the mask layer (90),
etching the polycrystalline layer (92) at grain boundaries, wherein grain centre regions and preferably grain boundary regions between only two adjacent grains are not etched away,
using the grain centre regions and preferably the residual grain boundary regions for patterning the mask layer (90) in an etching process,
patterning the material layer (84, 86) with the aid of the mask layer (90),
applying a metallic layer (102) after patterning the material layer (84, 86),
wherein parts of the metallic layer (102) extend into the patterned material layer (84, 86).

2. Method according to Claim 1, **characterized in that** the metallic layer (102) is applied to the patterned material layer by means of a deposition method, in particular by means of a method in which a silicide is deposited from the vapour phase.

## Revendications

1. Procédé de production d'un circuit (48) intégré, comprenant les stades de procédé suivants sans limitation par l'ordre indiqué :
mise à disposition d'un substrat (52),
production d'au moins un composant (50) électronique dans ou sur le substrat,
dépôt d'une couche (50) isolante électriquement après la production du composant (50),
production d'au moins un évidement (74, 76) dans la couche (70) isolante,
introduction d'une couche (84, 86) semiconductrice en un matériau monocristallin ou polycristallin dans l'évidement (74, 76),
dépôt d'une couche (90) de masque après l'introduction de la couche (84, 86) de matériau,
dépôt d'une couche (92) polycristalline après le dépôt de la couche (90) de masque,
attaque de la couche (92) polycristalline aux joints de grain, des zones de milieu de grain et, de préférence, des zones de joint de grain entre seulement deux grains voisins n'étant pas enlevées par attaque,
utilisation des zones de milieu de grain et, de préférence, des zones de joint de grain restantes pour la structuration de la couche (90) de masque dans une opération d'attaque,
structuration de la couche (84, 86) de matériau à l'aide de la couche (90) de masque,
dépôt d'une couche (102) métallique après la structuration de la couche (84, 86) de matériau,
des parties de la couche (102) métallique s'étendant dans la couche (84, 86) de matériau structuré.

2. Procédé suivant la revendication 1, **caractérisé en ce que** l'on dépose la couche (102) métallique sur la couche de matériau structuré par un procédé de dépôt, notamment par un procédé dans lequel un siliciure est déposé en phase gazeuse.
